# EUROPÄISCHE PATENTSCHRIFT

(11) **EP 3 821 118 B1**
(45) Veröffentlichungstag und Bekanntmachung des Hinweises auf die Patenterteilung: **18.10.2023**
(21) Anmeldenummer: 19728975.4
(22) Anmeldetag: 05.06.2019
(51) Int. Cl.: C23C 16/26, H01J 37/32, C23C 14/35, H01J 37/34, C23C 16/511, C23C 14/50, C23C 14/34, C23C 14/02, C23C 14/06, F02M 61/16, F02M 61/18

(54) **VERFAHREN ZUM BESCHICHTEN WENIGSTENS EINES METALLISCHEN BAUTEILS**
METHOD FOR COATING AT LEAST ONE METALLIC COMPONENT
PROCÉDÉ POUR REVÊTIR AU MOINS UNE PIÈCE MÉTALLIQUE

(30) Priorität: 12.07.2018 DE 102018211649
(43) Veröffentlichungstag der Anmeldung: 19.05.2021
(73) Patentinhaber: Robert Bosch GmbH, 70442 Stuttgart (DE)
(72) Erfinder: GUENTHER, Marcus, 70839 Gerlingen (DE)
(86) Internationale Anmeldenummer: PCT/EP2019/064638
(87) Internationale Veröffentlichungsnummer: WO 2020/011453

(56) Entgegenhaltungen:
- DE-A1-102011 080 898
- JP-A- 2018 006 300
- KR-A- 20180 007 536
- US-A- 5 427 827
- STRANAK V ET AL: "Highly ionized physical vapor deposition plasma source working at very low pressure", APPLIED PHYSICS LETTERS, A I P PUBLISHING LLC, US, Bd. 100, Nr. 14, 2. April 2012 (2012-04-02), Seiten 141604-141604, XP012155459, ISSN: 0003-6951, DOI: 10.1063/1.3699229 [gefunden am 2012-04-02]

## Beschreibung

Die Erfindung betrifft ein Verfahren zum Beschichten wenigstens eines metallischen Bauteils, insbesondere wenigstens einer Einspritzdüse, und eine Vorrichtung, die insbesondere zur Durchführung eines derartigen Verfahrens geeignet ist.

### Stand der Technik

Um z.B. Verschleißeffekten, welche die Funktionstüchtigkeit von Bauteilen beeinträchtigen und/oder deren Lebensdauer begrenzen können, entgegenzuwirken, werden häufig besonders stark beanspruchte Bauteile mit Verschleißschutzschichten beschichtet. Insbesondere bei Düsenkörpern als Komponenten von Kraftstoffeinspritzdüsen stellt sich das Problem, dass insbesondere die Innenflächen der im Düsenkörper eingelassenen Einspritzlöcher, deren Größe das Einspritzverhalten der Kraftstoffeinspritzdüse beeinflusst, mit herkömmlichen Beschichtungsverfahren wie z.B. CVD ("chemical vapor deposition") oder ALD ("atomic layer deposition") kaum zufriedenstellend beschichtbar ist, da einerseits die bei CVD erforderlichen hohen Prozesstemperaturen das zugrundeliegende Substratmaterial chemisch stark reduzieren und andererseits mit ALD verfahrensbedingt nicht ausreichend dicke Schichten abscheidbar sind. Obgleich sog. DLC-Schichten ("diamond-like coating") als Verschleißschutzschichten bei relativ niedrigen Prozesstemperaturen herstellbar sind, sind standardmäßig zu deren Abscheidung zur Verfügung stehende Verfahren wie z.B. PVD ("physical vapor deposition") und PECVD ("plasma enhanced chemical vapor deposition") zum Beschichten der Bohrungsinnenflächen von Einspritzlöchern weniger geeignet. So zeigen beispielsweise Untersuchungen von S. Miyagawa et al., die sich im Wesentlichen mit plasmabasierter lonenimplantation von auf Silizium-Substrat abgeschiedenen DLC-Schichten befassen, dass auf gekrümmten Stahlrohren mittels plasmabasierter Ionenimplantation abgeschiedene DLC-Schichten einen inhomogenen Schichtdickenverlauf aufweisen, wobei zudem die Schichtdicke auf den Rohrinnenflächen signifikant niedriger als an den Außenflächen ausgebildet ist (S. Miyagawa et al.: "Deposition of diamond-like carbon films using plasma based ion implantation with bipolar pulses", Surface and Coatings Technology 156 (2002) 322 - 327). Untersuchungen von S. Peter et al. offenbaren die Abscheidung von amorphen wasserstoffhaltigen Kohlenstoffschichten (a-C:H) und von amorphen wasserstoffhaltigen Silizium-Carbonitrid-Schichten (SiCN:H) mittels verschiedener plasmainduzierter CVD-Abscheideverfahren auf planaren Silizium-Wafern, also auf Halbleitersubstraten (S. Peter et al.: "Low temperature plasma enhanced chemical vapor deposition of thin films combining mechanical stiffness, electrical insulation, and homogeneity in microcavities", Journal of Applied Physics 108, 043303 (2010)). Weiterer relevanter Stand der Technik wird in STRANAK V ET AL: "Highly ionized physical vapor deposition plasma source working at very low pressure",APPLIED PHYSICS LETTERS, A I P PUBLISHING LLC, US, Bd. 100, Nr. 14, 2. April 2012 (2012-04-02), Seiten 141604-141604, XP012155459,ISSN: 0003-6951, DOI: 10.1063/1.3699229 und in

Patentdokument US 5 427 827 A offenbart.

### Offenbarung

Vorteile der Erfindung Die Erfindung ist in durch die angehängten Ansprüche definiert.

Das Verfahren mit den Merkmalen des Patentanspruchs 1 hat den Vorteil, dass damit Bauteile als dreidimensionale Substrate mit zumeist nichtplanaren Strukturen zuverlässig mit Funktions- bzw. Verschleißschutzschichten und/oder metallischen Haftschichten beschichtbar sind, indem nach Maßgabe des Schichttyps das Bauteil in ein Plasma eingetaucht wird, dessen Erzeugung mittels HiPIMS (Hochleistungsimpulsmagnetronsputtern: "high power impulse magnetron sputtering") im Falle einer Abscheidung aus der Festkörperphase oder mittels gepulst betriebener Plasmaimmersionsimplantation, die mit einer ECR-(Elektron-Zyklotronresonanz)-Plasmaquelle operiert, im Falle einer Abscheidung aus der Gasphase erfolgt. Insbesondere lassen sich dadurch nicht nur Außenflächen von Injektor-Einspritzdüsenkörpern, sondern auch die Innenflächen von deren typischerweise in Submillimeter-Größenordnung ausgebildeten Einspritzlochbohrungen beschichten, da einerseits mit den beiden Plasmaerzeugungsarten jeweils eine hohe Plasmadichte erzeugbar ist und andererseits durch den Kurzzeitpulsbetrieb mit Hochspannungspulsen im Mikrosekundenbereich Ladungsträger aus der Plasmaregion heraus mit hoher Geschwindigkeit im Takt der Pulsung schlagartig zu dem zu behandelnden Bauteil hin gelenkt bzw. beschleunigt, dort implantiert werden und mithin die Schichtausbildung in einer Dicke bewirken, mit der ein hoher und ausreichender Verschleißschutz erzielbar ist. Dazu umfasst das erfindungsgemäße Verfahren, das in einer eine HiPIMS-Anordnung und eine mit einer ECR-Plasmaquelle im Pulsbetrieb operierende Plasmaimmersionsimplantationsanordnung aufweisenden Prozesskammer abläuft, die Verfahrensschritte a) des Einbringens des wenigstens einen Bauteils als dreidimensionales Substrat in die Vakuumkammer, b) des Selektierens einer der Anordnungen in Abhängigkeit von einem aktuell auszubildenden Schichttyp, c) des Aktivierens der selektierten Anordnung, um eine Schicht in vorbestimmter Schichtdicke auszubilden, und d) des gegebenenfalls Wiederholens der Verfahrensschritte b) bis c) solange, bis Schichten unterschiedlichen Schichttyps auf dem Bauteil jeweils ausgebildet sind.

Weitere vorteilhafte Weiterbildungen und Ausgestaltungen der Erfindung ergeben sich durch die in den Unteransprüchen aufgeführten Maßnahmen.

Zweckmäßigerweise wird beim Selektieren und/oder Aktivieren der Plasmaimmersionsimplantationsanordnung wenigstens ein als Prekursor dienendes Gas oder Gasgemisch dosiert in die Vakuumkammer eingeleitet. Dabei gelangen die Gaspartikel in die von der ECR-Plasmaquelle erzeugte Plasmawolke, werden dort ionisiert und werden als Ionen zum Bauteil hin gelenkt. Bei solchen Prekursoren kann es sich um Kohlenwasserstoffe wie z.B. Ethin handeln, wenn eine als amorphe wasserstoffhaltige Kohlenstoffschicht ausgebildete Funktionsschicht abzuscheiden ist.

Das erfindungsgemäße Verfahren sieht vor, dass das wenigstens eine Bauteil mit Hochspannungspulsen eines der selektierten und aktivierten Anordnung zugehörigen Pulsgenerators ohne elektrische Zwischenschaltung eines dem Bauteil zugeordneten Substrathalters während des Verfahrensschritts c) elektrisch beaufschlagt wird. Dadurch ist es möglich, ausschließlich die zu beschichteten Bauteile mit im Mikrosekundenbereich gepulster Hochspannung zu beaufschlagen, während die zugeordneten Substratträger auf einem deutlich niedrigeren elektrischen Potential gehalten werden können, womit die Strombelastung verringert werden kann.

Um Abschattungseffekte während eines jeweils laufenden Abscheidungsvorgangs weitgehend zu vermeiden und eine möglichst homogene Beschichtung beispielsweise auch in Lochstrukturen eines Substrats zu erzielen, ist es zweckmäßig, wenn das wenigstens eine Bauteil in der Vakuumkammer während des Verfahrensschritts c) zumindest zeitweise bewegt wird und/oder wenn das wenigstens eine Bauteil um wenigstens eine Drehachse während des Verfahrensschritts c) zumindest zeitweise gedreht wird.

Ein Batch-Verfahren, das ein derartiges Verfahren umfasst, eignet sich aufgrund des weitgehend automatisierten Prozessablaufs zum Beschichten von Bauteilen in höheren Stückzahlen.

Ein Bauteil, das nach einem derartigen Verfahren beschichtet ist, weist vorteilhaft ein homogene und dauerhafte Beschichtung auf.

Bei einer Vorrichtung, die insbesondere zur Durchführung des erfindungsgemäßen Verfahrens dient, ist vorgesehen, dass eine als Vakuumkammer ausgebildete Prozesskammer eine HiPIMS-Anordnung und eine mit einer ECR-Plasmaquelle im Pulsbetrieb operierende Plasmaimmersionsimplantationsanordnung aufweist, und dass eine Steuerungs- und Koordinierungseinrichtung vorgesehen ist, welche mit den beiden Anordnungen zusammenwirkt, um in Abhängigkeit von einem aktuell auszubildenden Schichttyp eine der beiden Anordnungen zu selektieren, aktiv zu schalten und zu steuern. Dadurch lassen sich Bauteile sequentiell mit Schichten unterschiedlichen Schichttyps in einer einzigen Vorrichtung bzw. Anlage beschichten.

Eine Weiterbildung der Erfindung kann darin bestehen, dass die Steuerungs- und Koordinierungseinrichtung bei einer selektierten Anordnung deren zugehörigen Pulsgenerator hochspannungsausgangsseitig mit dem wenigstens einen Bauteil elektrisch verbindet. Indem die Steuerungs- und Koordinierungseinrichtung die Hochspannungspulse des jeweiligen Pulsgenerators nicht mit einem Substratträger elektrisch koppelt, sondern stattdessen eine direkte elektrische Verbindung zwischen dem Hochspannungsausgang des selektierten Pulsgenerators und dem wenigstens einen Bauteil bewirkt, lässt sich der - an sich hohe - Strombedarf der Vorrichtung begrenzt halten.

Eine Batch-Anlage, welche eine derartige Vorrichtung umfasst, eignet sich aufgrund ihrer Größe und ihres automatisierten Prozessablaufs zur Serienfertigung von Beschichtungen.

### Kurze Beschreibung der Zeichnungen

Ausführungsbeispiele der Erfindung sind in der nachfolgenden Beschreibung und in den beigefügten Zeichnungen näher erläutert. Letztere zeigen in schematisch gehaltenen Ansichten:
Fig. 1 eine im Schnitt gehaltene Teilansicht eines Düsenkörpers einer Kraftstoffeinspritzdüse mit im Kuppenbereich des Düsenkörpers vorgesehen Einspritzlöchern,
Fig. 2 eine Schnittdarstellung eines Schichtaufbaus eines metallischen Bauteils, welches ein Substrat, eine auf deren Oberfläche aufgebrachte Haftschicht, eine auf der Haftschicht aufgebrachte Gradientenschicht und eine darüberliegend aufgebrachte Funktionsschicht aufweist,
Fig. 3A ein Ablaufschema mit wesentlichen Verfahrensstufen des in einer Vakuumkammer ablaufenden erfindungsgemäßen Verfahrens zum Beschichten eines metallischen Bauteils,
Fig. 3B ein Ablaufschema mit wesentlichen Verfahrensstufen einer Ausführungsform des erfindungsgemäßen Verfahrens zum Beschichten eines metallischen Bauteils mit einem drei Schichten aufweisenden Schichtaufbau, und
Fig. 4 ein schematisch gehaltenes Blockschaltbild einer zur Durchführung des erfindungsgemäßen Verfahrens dienenden Vorrichtung mit einer Steuerungs- und Koordinierungseinrichtung, welche mit einer HiPIMS-Anordnung wie auch mit einer ECR-Anordnung und deren jeweils zugehörigen Pulsgeneratoren zusammenwirkt.

### Ausführungsformen der Erfindung

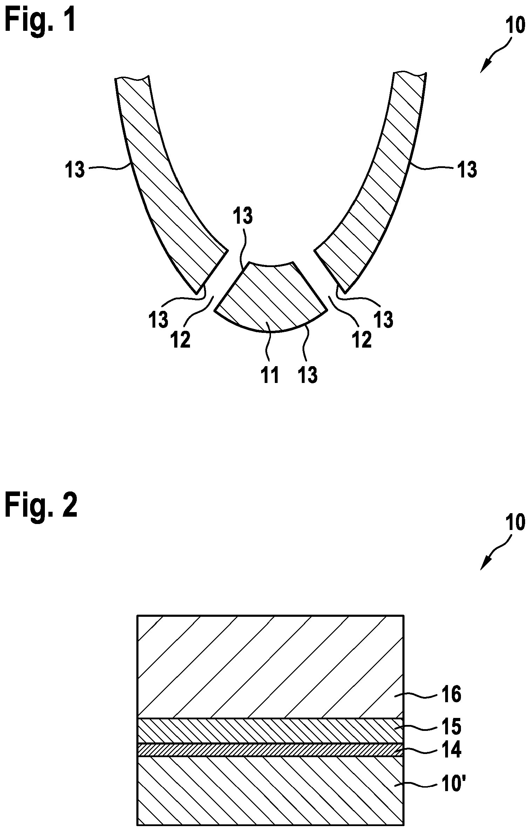

Fig. 1 zeigt ein im Ganzen mit 10 bezeichnetes Bauteil, das gemäß einem Ausführungsbeispiel als Düsenkörper einer Kraftstoffeinspritzdüse mit im Kuppenbereich 11 des Düsenkörpers angeordneten und dessen Wandung durchsetzenden Einspritzlöchern 12, wobei mittels des erfindungsgemäßen Verfahrens eine Beschichtung 13 sowohl auf die Außenflächen des Düsenkörpers als auch auf die Innenflächen der Einspritzlöcher 12 aufgebracht ist.

Fig. 2 zeigt in einer Querschnittansicht einen typischen Schichtaufbau eines gemäß dem erfindungsgemäßen Verfahren beschichteten Bauteils 10. Dabei ist auf der Oberfläche eines aus Stahl gebildeten Substrats 10' eine metallische Haftschicht 14 mittels Hochleistungsimpulsmagnetronsputtern (HiPIMS: high power impulse magnetron sputtering) aufgebracht. Auf der Haftschicht 14 ist eine Gradientenschicht 15 aufgebracht, deren Ausbildung ebenfalls mittels HiPIMS erfolgt. Schließlich ist auf der Gradientenschicht 15 eine Funktionsschicht 16 aufgebracht, bei der es sich typischerweise um eine amorphe wasserstoffhaltige Kohlenstoffschicht (a-C:H) oder eine Silizium-dotierte a-C:H-Schicht handelt und die mittels eines Elektron-Zyklotron-Resonanz-Plasmas (ECR: "electron cyclotron resonance") aus der Gasphase abgeschieden bzw. ausgebildet ist.

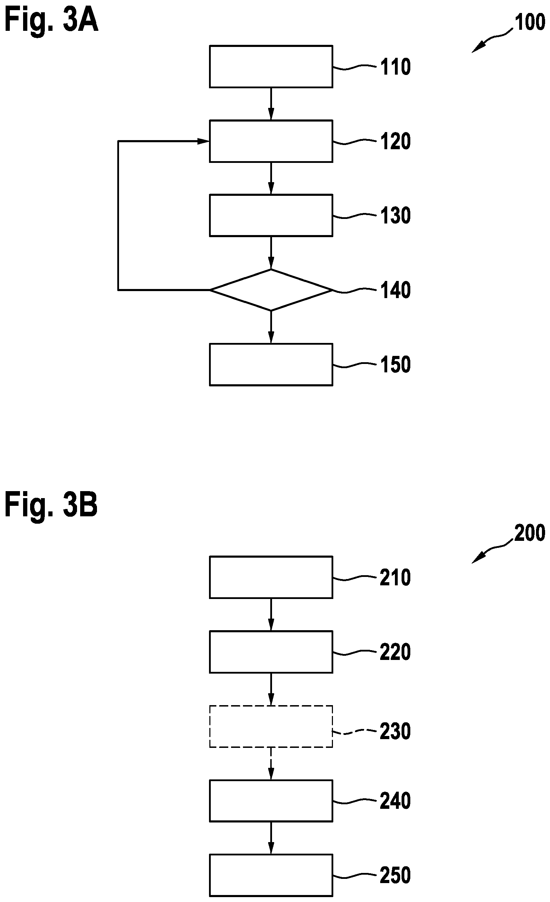

Fig. 3A zeigt ein Ablaufschema 100 mit den wesentlichen Verfahrensstufen 110 bis 150 einer Ausführungsform des erfindungsgemäßen Verfahrens, welches zum Beschichten eines metallischen Bauteils dient, wobei das Verfahren in einer Vakuumkammer abläuft, die zusammen mit weiteren Komponenten eine Vorrichtung zur Durchführung des erfindungsgemäßen Verfahrens bildet.

In einer ersten Verfahrensstufe 110, die im Wesentlichen der Prozessinitialisierung dient, werden die zu beschichtenden Bauteile zusammen mit ihren Substrathaltern in die Vakuumkammer eingeschleust, dort fixiert und an dafür vorgesehene elektrische Kontaktierungsmittel angeschlossen.

In einer zweiten Verfahrensstufe 120 wird - in Abhängigkeit vom aktuell auszubildenden Schichttyp - eine von zwei in der Vakuumkammer aufgenommenen Anordnungen ausgewählt. Bei den zwei Anordnungen handelt es sich einerseits um eine HiPIMS-Anordnung und andererseits um eine mit einer ECR-Plasmaquelle im Pulsbetrieb operierende Plasmaimmersionsimplantationsanordnung (nachstehend als PIII-Anordnung bezeichnet).

In einer dritten Verfahrensstufe 130 wird die aktuell ausgewählte Anordnung aktiviert und bleibt solange aktiviert bzw. in Betrieb, bis eine Schicht in gewünschter bzw. vorbestimmter Dicke ausgebildet ist. Danach wird die ausgewählte Anordnung deaktiviert.

Wird die HiPIMS-Anordnung selektiert und aktiviert, d.h. in Betrieb gesetzt, so wird ein Plasma mittels Glimmentladung gezündet, von dem zugeordneten Pulsgenerator erzeugte Hochspannungspulse an die Bauteile angelegt, wobei Ionen aus einem Targetmaterial zum den als Gegenelektrode beschalteten Bauteilen gelenkt und dort implantiert werden; ein Magnetfeld dient zur Steigerung der Abscheiderate. Je nach Maßgabe des eingesetzten Targetmaterials sind mithin durch Festkörperabscheidung metallische Schichten unterschiedlicher Natur z.B. auf der Basis von Ti, Cr, W, Mo oder dergleichen ausbildbar.

Wird die mit einer ECR-Plasmaquelle operierende PIII-Anordnung selektiert und aktiviert, d.h. in Betrieb gesetzt, so wird ein Plasma mittels Mikrowellen-Resonanzabsorption in Ladungsträgern gezündet, die in Magnetfeldbahnen umlaufen, wobei einerseits Gase als Prekursoren in die Vakuumkammer eingeleitet werden und andererseits von einem zugeordneten Pulsgenerator erzeugte Hochspannungspulse an die Bauteile angelegt werden, wobei Ionen aus dem Plasma zu den mit einem Bias-Potential versehenen Bauteilen gelenkt und dort implantiert werden. Liegt während der Pulsung das Substrat kurzzeitig auf Massepotential, so bildet sich zwischen Substrat und Plasmawolke ein Dunkelraum im Bereich der Debye-Länge aus, welche im Wesentlichen von der Plasmadichte und der Elektronentemperatur abhängig ist und für typische ECR-Entladungen in der Größenordnung von einem Zehntel mm liegt, wodurch es dem Plasma möglich ist, auch relativ kleinen Strukturänderungen des Substrats zu folgen; liegt nun während der Pulsung ein negativer Spannungsimpuls an dem Substrat an, so werden schlagartig Ionen aus dem Plasma zum Substrat hin beschleunigt, wobei zugleich der Dunkelraum expandiert, bis er eine dem gerade anliegenden Spannungsimpuls entsprechende Größe annimmt; in der darauffolgenden Pulsperiode wird die Spannung wieder ausgestellt, d.h. das Substrat wird auf Massepotential gezogen, worauf sich erneut wieder der Ausgangszustand einstellt. Aufgrund der kurzen Pulsung (im Mikrosekundenbereich) mit Hochspannungspulsen (im unteren kV-Bereich von 0,5 bis etwa 10 kV) ist es möglich, Bauteile und deren Bohrungsinnenwände gleichermaßen zu beschichten.

In einer vierten Verfahrensstufe 140 erfolgt eine Abfrage, ob eine weitere Schicht ausgebildet werden soll. Bei positivem Abfrageresultat erfolgt ein Rücksprung zur Verfahrensstufe 120, wonach erneut eine der beiden Anordnungen ausgewählt und anschließend gemäß Stufe 130 aktiviert wird, während bei negativem Abfrageresultat das Verfahren zur fünften Verfahrensstufe 150 übergeht.

In der fünften Verfahrensstufe 150 wird das Verfahren beendet, wobei die fertig beschichteten Substrate bzw. Bauteile aus der Vakuumkammer ausgeschleust werden.

Fig. 3B zeigt ein Ablaufschema 200 mit wesentlichen Verfahrensstufen 210 bis 250 einer Ausführungsvariante des erfindungsgemäßen Verfahrens, welche zum Beschichten eines metallischen Bauteils mit einem Schichtaufbau gemäß Fig. 2 dient.

In einer ersten Verfahrensstufe 210, welche im Wesentlichen der Prozessinitialisierung dient, werden Substrathalter mit darauf angeordneten und zum Beschichten vorgesehenen Bauteilen in die Vakuum- bzw. Prozesskammer eingeschleust, worauf die Bauteile als dreidimensionale Substrate direkt an elektrische Kontaktleitungen bzw. -schienen angeschlossen werden, welche über eine Steuerungs- und Koordinierungseinrichtung mit jeweils einem von zwei Hochspannungspulsgeneratoren elektrisch wirkverbindbar sind, von denen ein Hochspannungspulsgenerator der HiPIMS-Anordnung zugehörig ist, während der andere Hochspannungspulsgenerator der mit der ECR-Plasmaquelle operierenden PIII-Anordnung zugehörig ist. Die erste Verfahrensstufe 210 wird abgeschlossen, indem die Vakuumkammer evakuiert wird, bis der erforderliche Prozessdruck erreicht ist.

Während einer sich daran anschließenden zweiten Verfahrensstufe 220 wird gemäß einem bevorzugten Ausführungsbeispiel eine metallische Haftschicht, die typischerweise aus Chromnitrid gebildet sein kann, auf der Substratoberfläche aufgebracht. Dazu wird über die Steuerungs- und Koordinierungseinrichtung die HiPIMS-Anordnung und der zugehörige Hochspannungspulsgenerator aktiviert. Die zweite Verfahrensstufe 220 wird abgeschlossen, indem über die Steuerungs- und Koordinierungseinrichtung die HiPIMS-Anordnung und der zugehörige Hochspannungspulsgenerator deaktiviert werden.

In einer dritten Verfahrensstufe 230, die optional in Abhängigkeit davon ausgebildet ist, ob eine Gradientenschicht auf der zuvor ausgebildeten Haftschicht aufgebracht wird oder nicht, wird erneut die HiPIMS-Anordnung und deren Hochspannungspulsgenerator über die Steuerungs- und Koordinierungseinrichtung aktiviert, um aus der Festkörperphase die Gradientenschicht auszubilden, bei welcher die Konzentration des Metallgehalts gemäß einem vorbestimmten Profil allmählich abnimmt, um einen abrupten Übergang zur anschließenden Funktionsschicht zu vermeiden. Die dritte Verfahrensstufe 230 wird abgeschlossen, indem über die Steuerungs- und Koordinierungseinrichtung die HiPIMS-Anordnung und deren Hochspannungspulsgenerator deaktiviert werden.

In einer vierten Verfahrensstufe 240 wird schließlich aus Verschleißschutzgründen eine Funktionsschicht auf der darunterliegenden Schicht aufgebracht. Da die Funktionsschicht typischerweise als amorphe wasserstoffhaltige Kohlenstoffschicht (a-C:H) oder als Silizium-dotierte a-C:H-Schicht ausgebildet wird, ist es - im Unterschied zu den beiden vorherigen Verfahrensstufen 120, 130 - erforderlich, einen anderen Abscheidungsmodus zu wählen, bei dem die Abscheidung aus der Gasphase erfolgt. Dazu wird über die Steuerungs- und Koordinierungseinrichtung die mit der ECR-Plasmaquelle operierende PIII-Anordnung und deren Hochspannungspulsgenerator ausgewählt und aktiviert; zugleich wird ein oder gegebenenfalls. mehrere Gaseinlassventile für die Zufuhr von Kohlenwasserstoffen (z.B. Methan, Ethin, Isobutan oder dergleichen) zur Vakuumkammer freigeschaltet, um diese Gase oder Gasgemische als Prekursoren dosiert in die Vakuumkammer einzulassen und mithin die Abscheidung der amorphen Kohlenstoffschicht auf der darunterliegenden Schicht zu ermöglichen. Als Prekursoren eignen sich außer den gängigen Kohlenwasserstoffen auch siliziumhaltige Kohlenwasserstoffe (wie z.B. Silane), die durch Edelgase und Wasserstoff ergänzt werden können. Die vierte Verfahrensstufe 240 wird abgeschlossen, indem über die Steuerungs- und Koordinierungseinrichtung die mit der ECR-Plasmaquelle operierende PIII-Anordnung und deren Hochspannungspulsgenerator deaktiviert werden und zugleich die Gaszufuhr von Ethin in die Vakuumkammer abgesperrt wird.

In einer fünften Verfahrensstufe 250 wird das erfindungsgemäße Verfahren beendet, wobei die elektrischen Kontaktierungen der nunmehr beschichteten Substrate gelöst werden und die Substrathalter zusammen mit den Substraten aus der Vakuumkammer ausgeschleust werden.

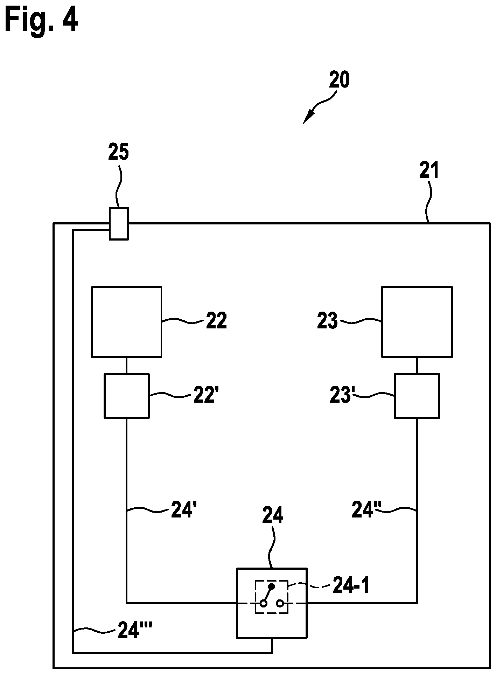

Die zur Durchführung des erfindungsgemäßen Verfahrens geeignete Vorrichtung 20 (Fig. 4) umfasst im Wesentlichen eine als Vakuumkammer ausgebildete Prozesskammer 21, eine HiPIMS-Anordnung 22 und eine mit einer ECR-Plasmaquelle im Pulsbetrieb operierende PIII-Anordnung 23 zusammen mit den zugehörigen Pulsgeneratoren 22', 23', ferner Gaseinlasszuführungen bzw. - ventile 25, mit denen ein Edelgas einerseits und Kohlenwasserstoffe zum Ausbilden von DLC-Funktionsschichten andererseits in die Vakuumkammer einleitbar sind, zudem Substratträger (nicht dargestellt), die bewegbar und/oder drehbar ausgebildet sind, und eine Steuerungs- und Koordinierungseinrichtung 24, die über elektrische Leitungen 24', 24", 24'" mit den Anordnungen 22, 23 und den Gasventilen 25 zusammenwirkt, um eine sequentielle Beschichtung der dreidimensionalen Substrate zu erzielen. Dazu selektiert und aktiviert die Steuerungs- und Koordinierungseinrichtung 24 in Abhängigkeit und nach Maßgabe von einem aktuell auszubildenden Schichttyp eine der beiden Anordnungen 22, 23, wobei die Steuerungs- und Koordinierungseinrichtung 24 eine Schaltfunktion aufweist, die anhand des Bezugszeichens 24-1 stark vereinfacht in Fig. 4 dargestellt ist. Zur Veranschaulichung ist in der in Fig. 4 dargestellten Schaltstellung der Schaltfunktion 24-1 die HiPIMS-Anordnung 22 selektiert, während die PIII-Anordnung 23 in dieser Schaltstellung inaktiv geschaltet ist. Die Steuerungs- und Koordinierungseinrichtung 24 sowie die den Anordnungen 22, 23 zugeordneten Pulsgeneratoren 22', 23' sind aus physikalischen Gründen außerhalb der Vakuumkammer 21 angeordnet.

Zusammenfassend dient das erfindungsgemäße Verfahren 100 zum Beschichten wenigstens eines metallischen Bauteils, insbesondere wenigstens eines Düsenkörpers einer Einspritzdüse, wobei das Verfahren in einer eine HiPIMS-Anordnung und eine mit einer ECR-Plasmaquelle im Pulsbetrieb operierende PIII-Anordnung aufweisenden Prozesskammer abläuft, mit folgenden Verfahrensschritten: a) Einbringen des wenigstens einen Bauteils als dreidimensionales Substrat in die Vakuumkammer gemäß Verfahrensstufe 110, b) Selektieren einer der Anordnungen in Abhängigkeit von einem aktuell auszubildenden Schichttyp gemäß Verfahrensstufe 120, c) Aktivieren der selektierten Anordnung gemäß Verfahrensstufe 130, um eine Schicht in vorbestimmter Schichtdicke auszubilden, und d) gegebenenfalls Wiederholen der Verfahrensstufen 120 bis 130 solange, bis Schichten unterschiedlichen Schichttyps auf dem Bauteil jeweils ausgebildet sind. Im Speicherbereich der Steuerungs- und Koordinierungseinrichtung 24 der zur Durchführung des Verfahrens dienenden Vorrichtung 20 ist das Ablaufprogramm des erfindungsgemäßen Verfahrens gemäß Fig. 3A und 3B implementiert, so dass sich dadurch ein weitgehend automatisierter Prozessablauf ergibt, da die Steuerungs- und Koordinierungseinrichtung 24 mit der HiPIMS-Anordnung 22 als auch mit der PIII-Anordnung 23 und deren jeweils zugehörigen Pulsgeneratoren 22', 23' verschaltet ist und zusammenwirkt, ferner schaltet und regelt die Steuerungs- und Koordinierungseinrichtung 24 auch die Gaseinlassventile 25 in Koordination mit der zugeordneten Anordnung 22, 23, wodurch ein Edelgas einerseits und Kohlenwasserstoffe für die Ausbildung einer DLC-Funktionsschicht andererseits in die Vakuumkammer einleitbar sind. Insgesamt lässt sich mithin eine sequentielle Beschichtung des Substrats mit wenigstens einer metallischen Haftschicht und wenigstens einer DLC-Funktionsschicht steuern.

## Patentansprüche

1. Verfahren zum Beschichten wenigstens eines metallischen Bauteils, insbesondere wenigstens eines Düsenkörpers einer Einspritzdüse, wobei das Verfahren in einer eine HiPIMS-Anordnung und eine mit einer ECR-Plasmaquelle im Pulsbetrieb operierende Plasmaimmersionsimplantationsanordnung aufweisenden als Vakuumkammer ausgebildeten Prozesskammer abläuft, mit folgenden Verfahrensschritten:
a) Einbringen (110) des wenigstens einen Bauteils als dreidimensionales Substrat in die Vakuumkammer,
b) Selektieren (120) einer der Anordnungen in Abhängigkeit von einem aktuell auszubildenden Schichttyp,
c) Aktivieren (130) der selektierten Anordnung, um eine Schicht in vorbestimmter Schichtdicke auszubilden, und
d) gegebenenfalls Wiederholen der Verfahrensschritte b) bis c) solange, bis Schichten unterschiedlichen Schichttyps auf dem Bauteil jeweils ausgebildet sind,
wobei das wenigstens eine Bauteil mit Hochspannungspulsen eines der selektierten und aktivierten Anordnung zugehörigen Pulsgenerators ohne elektrische Zwischenschaltung eines dem wenigstens einen Bauteil zugeordneten Substratträgers während des Verfahrensschritts c) elektrisch beaufschlagt wird und wobei beim Selektieren (120) und/oder Aktivieren (130) der Plasmaimmersionsimplantationsanordnung wenigstens ein als Prekursor dienendes Gas oder Gasgemisch dosiert in die Vakuumkammer eingeleitet wird.

2. Verfahren nach Anspruch 1, **dadurch gekennzeichnet, dass** das wenigstens eine Bauteil in der Vakuumkammer während des Verfahrensschritts c) zumindest zeitweise bewegt wird.

3. Verfahren nach Anspruch 1 oder 2, **dadurch gekennzeichnet, dass** das wenigstens eine Bauteil um wenigstens eine Drehachse während des Verfahrensschritts c) zumindest zeitweise gedreht wird.

4. Batch-Verfahren umfassend ein Verfahren nach einem der Ansprüche 1 bis 3.

5. Vorrichtung insbesondere zur Durchführung des Verfahrens nach einem der Ansprüche 1 bis 4, **dadurch gekennzeichnet, dass** eine als Vakuumkammer (21) ausgebildete Prozesskammer eine HiPIMS-Anordnung (22) und eine mit einer ECR-Plasmaquelle im Pulsbetrieb operierende Plasmaimmersionsimplantationsanordnung (23) aufweist, und dass eine Steuerungs- und Koordinierungseinrichtung (24) vorgesehen ist, welche mit den beiden Anordnungen (22, 23) zusammenwirkt, um in Abhängigkeit von einem aktuell auszubildenden Schichttyp eine der beiden Anordnungen (22, 23) zu selektieren, aktiv zu schalten und zu steuern, wobei wenigstens ein als dreidimensionales Substrat in die Vakuumkammer eingebrachtes metallisches Bauteil mit Hochspannungspulsen eines der selektierten und aktivierten Anordnung zugehörigen Pulsgenerators ohne elektrische Zwischenschaltung eines dem wenigstens einen Bauteil zugeordneten Substratträgers während des Aktivierens elektrisch beaufschlagt wird und wobei beim Selektieren (120) und/oder Aktivieren (130) der Plasmaimmersionsimplantationsanordnung wenigstens ein als Prekursor dienendes Gas oder Gasgemisch dosiert in die Vakuumkammer eingeleitet wird.

6. Vorrichtung nach Anspruch 5, **dadurch gekennzeichnet, dass** die Steuerungs- und Koordinierungseinrichtung (24) bei einer selektierten Anordnung (22, 23) deren zugehörigen Pulsgenerator (22', 23') hochspannungsausgangsseitig mit dem wenigstens einen Bauteil direkt elektrisch verbindet.

7. Batch-Anlage umfassend eine Vorrichtung gemäß Anspruch 5 oder 6.

## Claims

1. Method for coating at least one metallic component, in particular at least one nozzle body of an injection nozzle, wherein the method takes place in a process chamber in the form of a vacuum chamber comprising an HiPIMS arrangement and a plasma immersion implantation arrangement which operates in pulsed operation with an ECR plasma source, comprising the following method steps:
a) introducing (110) the at least one component as a three-dimensional substrate into the vacuum chamber,
b) selecting (120) one of the arrangements in dependence on a layer type to be formed currently,
c) activating (130) the selected arrangement, in order to form a layer of predetermined layer thickness, and
d) optionally repeating method steps b) to d) until layers of different layer type have each been formed on the component,
wherein, during method step c) , the at least one component is acted on electrically by high-voltage pulses of a pulse generator associated with the selected and activated arrangement without electrical interposition of a substrate carrier assigned to the at least one component, and wherein, when selecting (120) and/or activating (130) the plasma immersion implantation arrangement, at least one gas or gas mixture serving as precursor is introduced into the vacuum chamber in a metered manner.

2. Method according to Claim 1, **characterized in that** the at least one component is at least intermittently moved in the vacuum chamber during method step c).

3. Method according to Claim 1 or 2, **characterized in that** the at least one component is at least intermittently rotated about at least one axis of rotation during method step c).

4. Batch method comprising a method according to one of Claims 1 to 3.

5. Apparatus in particular for carrying out the method according to one of Claims 1 to 4, **characterized in that** a process chamber in the form of a vacuum chamber (21) comprises an HiPIMS arrangement (22) and a plasma immersion implantation arrangement (23) which operates in pulsed operation with an ECR plasma source, and **in that** a control and coordination device (24) is provided, which cooperates with the two arrangements (22, 23), in order to select, to activate and to control one of the two arrangements (22, 23) in dependence on a layer type to be formed currently, wherein, during the activation, at least one metallic component introduced as three-dimensional substrate into the vacuum chamber is acted on electrically by high-voltage pulses of a pulse generator associated with the selected and activated arrangement without electrical interposition of a substrate carrier assigned to the at least one component, and wherein, when selecting (120) and/or activating (130) the plasma immersion implantation arrangement, at least one gas or gas mixture serving as precursor is introduced into the vacuum chamber in a metered manner.

6. Apparatus according to Claim 5, **characterized in that**, in the case of a selected arrangement (22, 23), the control and coordination device (24) directly electrically connects the associated plasma generator (22', 23') thereof to the at least one component on the high-voltage-output side.

7. Batch installation comprising an apparatus according to Claim 5 or 6.

## Revendications

1. Procédé de revêtement d'au moins un composant métallique, notamment d'au moins un corps de buse d'une buse d'injection, le procédé se déroulant dans une chambre de traitement configurée sous forme de chambre à vide, présentant un agencement HiPIMS et un agencement d'implantation par immersion dans un plasma fonctionnant en mode pulsé avec une source de plasma ECR, avec les étapes de procédé suivantes :
a) l'introduction (110) de l'au moins un composant sous forme de substrat tridimensionnel dans la chambre à vide,
b) la sélection (120) de l'un des agencements en fonction d'un type de couche à former actuellement,
c) l'activation (130) de l'agencement sélectionné pour former une couche d'une épaisseur de couche prédéterminée, et
d) le cas échéant, la répétition des étapes de procédé b) à c) jusqu'à ce que des couches de différents types de couche soient respectivement formées sur le composant, dans lequel l'au moins un composant est sollicité électriquement pendant l'étape de procédé c) avec des impulsions à haute tension d'un générateur d'impulsions associé à l'agencement sélectionné et activé, sans interposition électrique d'un support de substrat associé à l'au moins un composant, et dans lequel, lors de la sélection (120) et/ou de l'activation (130) de l'agencement d'implantation par immersion dans un plasma, au moins un gaz ou mélange de gaz servant de précurseur est introduit de manière dosée dans la chambre à vide.

2. Procédé selon la revendication 1, **caractérisé en ce que** l'au moins un composant est déplacé au moins temporairement dans la chambre à vide pendant l'étape de procédé c) .

3. Procédé selon la revendication 1 ou 2, **caractérisé en ce que** l'au moins un composant est mis en rotation au moins temporairement autour d'au moins un axe de rotation pendant l'étape de procédé c).

4. Procédé par lots comprenant un procédé selon l'une quelconque des revendications 1 à 3.

5. Dispositif notamment pour la mise en œuvre du procédé selon l'une quelconque des revendications 1 à 4, **caractérisé en ce qu'**une chambre de traitement configurée sous forme de chambre à vide (21) présente un agencement HiPIMS (22) et un agencement d'implantation par immersion dans un plasma (23) fonctionnant en mode pulsé avec une source de plasma ECR, et **en ce qu'**il est prévu un appareil de commande et de coordination (24) qui coopère avec les deux agencements (22, 23) pour sélectionner, activer et commander l'un des deux agencements (22, 23) en fonction d'un type de couche à former actuellement, dans lequel au moins un composant métallique introduit dans la chambre à vide sous forme de substrat tridimensionnel est sollicité électriquement pendant l'activation avec des impulsions à haute tension d'un générateur d'impulsions associé à l'agencement sélectionné et activé, sans interposition électrique d'un support de substrat associé à l'au moins un composant, et dans lequel, lors de la sélection (120) et/ou de l'activation (130) de l'agencement d'implantation par immersion dans un plasma, au moins un gaz ou mélange de gaz servant de précurseur est introduit de manière dosée dans la chambre à vide.

6. Dispositif selon la revendication 5, **caractérisé en ce que** lorsqu'un agencement (22, 23) est sélectionné, l'appareil de commande et de coordination (24) relie directement électriquement son générateur d'impulsions (22', 23') associé, côté sortie à haute tension, à l'au moins un composant.

7. Installation par lots comprenant un dispositif selon la revendication 5 ou 6.
